(19) Europäisches Patentamt
European Patent Office
Office européen des brevets

(11) **EP 3 495 860 B1**

(12) **FASCICULE DE BREVET EUROPEEN**

(45) Date de publication et mention
de la délivrance du brevet:
**16.09.2020 Bulletin 2020/38**

(51) Int Cl.:
**G02B 6/13** *(2006.01)*  **G02B 6/10** *(2006.01)*
**G02B 6/12** *(2006.01)*  **H01L 21/02** *(2006.01)*

(21) Numéro de dépôt: **18211025.4**

(22) Date de dépôt: **07.12.2018**

(54) **PROCÉDÉ DE RÉALISATION DE GUIDES D'ONDE À COEURS À BASE DE GE**

VERFAHREN ZUR HERSTELLUNG VON WELLENLEITERN MIT KERNEN AUF GE-BASIS

METHOD FOR MANUFACTURING WAVE GUIDES WITH GE BASE CORES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **08.12.2017 FR 1761862**

(43) Date de publication de la demande:
**12.06.2019 Bulletin 2019/24**

(73) Titulaire: **Commissariat à l'Energie Atomique et aux Energies Alternatives**
**75015 Paris (FR)**

(72) Inventeurs:
• **HARTMANN, Jean-Michel**
 **38330 Montbonnot-Saint-Martin (FR)**
• **BRUN, Mickaël**
 **38320 Eybens (FR)**
• **FEDELI, Jean-Marc**
 **38120 Saint-Egreve (FR)**
• **FOURNIER, Maryse**
 **38410 St Martin D'Uriage (FR)**

(74) Mandataire: **Hautier, Nicolas**
 **Cabinet Hautier**
 **20, rue de la Liberté**
 **06000 Nice (FR)**

(56) Documents cités:
 **FR-A1- 3 028 094  US-B1- 7 037 856**

• **MICKAEL BRUN ET AL: "Low loss SiGe graded index waveguides for mid-IR applications", OPTICS EXPRESS, vol. 22, no. 1, 13 janvier 2014 (2014-01-13), pages 508-518, XP055499165, US ISSN: 1094-4087, DOI: 10.1364/OE.22.000508**
• **GRILLET C ET AL: "Low loss SiGe waveguides in the MID-IR", 2013 CONFERENCE ON LASERS & ELECTRO-OPTICS EUROPE & INTERNATIONAL QUANTUM ELECTRONICS CONFERENCE CLEO EUROPE/IQEC, IEEE, 12 mai 2013 (2013-05-12), page 1, XP032587897, DOI: 10.1109/CLEOE-IQEC.2013.6801419**
• **SAMOILOV A ET AL: "INCREASE OPTICAL BANDWIDTH WITH EPI CVD", ELECTRONIC PACKAGING AND PRODUCTION, CAHNERS PUBLISHING CO, NEWTON, MASSACHUSETTS, US, vol. 42, no. 11, 1 novembre 2002 (2002-11-01), XP001144939, ISSN: 0013-4945**

**Description**

DOMAINE TECHNIQUE DE L'INVENTION

L'invention concerne le domaine des guides d'onde optiques. Elle trouve pour application particulièrement avantageuse la fabrication de guides d'onde adaptés au spectre du moyen infrarouge.

ÉTAT DE LA TECHNIQUE

Dans le domaine des guides d'onde optiques configurés pour confiner et propager un flux lumineux présentant une longueur d'onde appartenant au spectre du moyen infrarouge (MIR), une technologie consiste généralement à fabriquer un guide d'onde comprenant un cœur et une gaine entourant le cœur, le cœur et la gaine présentant un contraste d'indices optiques suffisamment élevé pour confiner le flux lumineux dans le cœur du guide d'onde.

En particulier, pour des longueurs d'onde de flux lumineux comprises entre 3 $\mu$m et 8 $\mu$m ($10^{-6}$ mètres), un tel guide d'onde MIR par contraste d'indices peut comprendre un cœur en silicium-germanium (SiGe) avec une concentration en germanium de quelques dizaines de pourcents atomiques, et une gaine en silicium (Si).

Pour des longueurs d'onde de flux lumineux comprises entre 8 $\mu$m et 15 $\mu$m, un tel guide d'onde MIR par contraste d'indices peut comprendre un cœur en germanium (Ge), et une gaine en silicium-germanium (SiGe) avec une concentration en germanium de quelques dizaines de pourcents atomiques.

Les cœurs de ces guides d'onde MIR ont généralement des sections sensiblement rectangulaires présentant des dimensions en hauteur et en largeur de plusieurs micromètres, lesdites sections étant prises perpendiculairement à la direction principale de propagation des flux lumineux correspondants.

Les gaines de ces guides d'onde MIR présentent également des épaisseurs de plusieurs micromètres, de manière à confiner des flux lumineux ayant des longueurs d'onde de plusieurs micromètres.

Les procédés de fabrication utilisés pour fabriquer ces guides d'onde MIR comprennent généralement une étape de dépôt d'une première couche à base de germanium de forte épaisseur (typiquement 3 à 6 $\mu$m) sur un substrat préalablement préparé, une étape de formation du cœur par lithographie et gravure de cette première couche, et une étape de dépôt d'une deuxième couche de forte épaisseur (typiquement 6 à 12 $\mu$m) de sorte à former la gaine du guide d'onde par encapsulation ou enrobage du cœur.

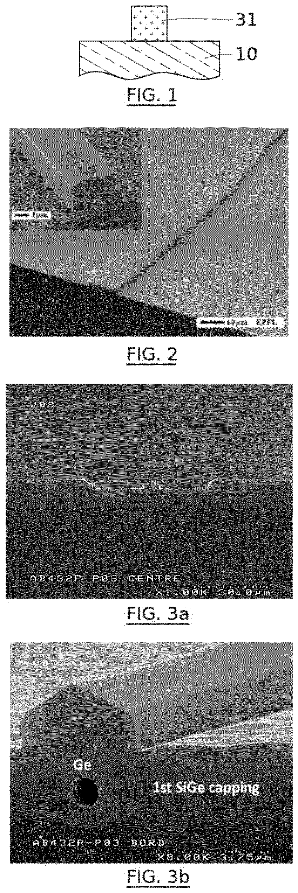

Les figures 1 et 2 illustrent schématiquement et par microscopie électronique à balayage un guide d'onde en cours de fabrication, après formation du cœur. L'article de Mickael Brun et al. "Low loss SiGe graded index waveguides for mid-IR applications" paru dans le volume 22 du journal OPTICS EXPRESS décrit un procédé selon le préambule de la revendication 1.

Expérimentalement, il a été montré qu'un tel guide d'onde présente, après encapsulation du cœur, de bonnes performances pour le confinement et la propagation d'un flux lumineux MIR.

Un enjeu est de fabriquer de tels guides d'onde avec un rendement industriel.

Cependant, dans le cadre du développement de la présente invention, il s'est avéré que les procédés de fabrication habituellement mis en œuvre dans un contexte de production industrielle conduisent à des guides d'onde dont les performances sont dégradées.

Il existe donc un besoin consistant à proposer une solution pour fabriquer de manière industrielle ce type de guide d'ondes, ceci sans altérer leurs performances.

Un objet de la présente invention est de répondre à ce besoin.

Les autres objets, caractéristiques et avantages de la présente invention apparaîtront à l'examen de la description suivante et des dessins d'accompagnement. Il est entendu que d'autres avantages peuvent être incorporés.

RÉSUMÉ DE L'INVENTION

Pour atteindre cet objectif, la présente invention prévoit, selon un premier aspect, un procédé de réalisation d'un guide d'onde comprenant au moins un cœur et une gaine, le procédé comprenant au moins les étapes suivantes:

- Fournir un substrat,
- Déposer une couche à base de germanium (Ge) sur le substrat,
- Former le cœur du guide d'onde dans ladite couche à base de Ge,
- Déposer une couche d'encapsulation autour du cœur, la couche d'encapsulation présentant une teneur en germanium $t_{Ge\ encapsulation}$ nulle ou telle que :

$t_{Ge\ encapsulation} \leq 0{,}9\ t_{Ge\ coeur}$,

$t_{Ge\ coeur}$ étant la teneur en germanium du cœur, de manière à former au moins partiellement la gaine,

De manière avantageuse, le procédé comprend en outre, avant l'étape de dépôt de la couche d'encapsulation, au moins l'étape suivante :

- Déposer par épitaxie une coquille autour du cœur, ladite coquille formant au moins partiellement ladite gaine et présentant une teneur en germanium $t_{Ge\ coquille}$ nulle ou telle que :

$t_{Ge\ coquille} \leq 0,9\ t_{Ge\ coeur}$,

le dépôt par épitaxie de la coquille étant effectué à une température :

$T_{épitaxie\ coquille} \leq 780°C$.

Par ailleurs, ladite couche d'encapsulation est avantageusement déposée par épitaxie à une température $T_{épitaxie\ encapsulation}$ telle que :

$T_{épitaxie\ encapsulation} \geq 1,08 * T_{épitaxie\ coquille}$.

Le procédé proposé par la présente invention procure de nombreux avantages qui vont être détaillés ci-dessous.

Habituellement, les procédés de fabrication industriels classiques utilisent des températures de dépôt élevées pour déposer ou faire croître des couches de forte épaisseur à base de Si ou de SiGe. Ces dépôts haute température permettent d'obtenir des vitesses de croissance élevées pour ces couches (typiquement supérieures à 100 nm.min$^{-1}$). Ces vitesses de croissance élevées permettent de limiter un temps de traitement par plaque et contribuent à obtenir des rendements industriels pour ces procédés de fabrication industriels classiques.

En particulier, lors de la formation de la gaine par encapsulation du cœur, les températures de dépôt de la deuxième couche dite couche d'encapsulation sont habituellement supérieures ou égales à 850°C.

Cependant, dans le cadre du développement de la présente invention, il a été observé que le cœur était sensiblement altéré après encapsulation par ces procédés de fabrication industriels classiques.

En particulier, cette altération se traduit par une déformation des surfaces libres du cœur. L'apparition de facettes aux coins supérieurs du cœur peut par exemple être observée. La section du cœur n'est dès lors plus rectangulaire.

Dans certains cas observés lors du développement de la présente invention, cette altération se traduit également par un évidement partiel du cœur du guide d'onde.

Ces altérations apparaissent sur les figures 3a et 3b.

La présente invention a pour objet un procédé de réalisation d'un guide d'onde MIR compatible avec les rendements industriels et préservant notamment l'intégrité du cœur. Elle est définie par les présentes revendications.

Pour cela, après formation du cœur, le procédé selon l'invention comprend une étape de dépôt d'une coquille significativement moins riche en germanium que le cœur et déposée à « basse température ».

Ce dépôt basse température évite une augmentation trop importante de la mobilité des atomes du cœur au niveau des surfaces libres. Or, dans le cadre du développement de la présente invention, il a été identifié que l'altération du cœur provient au moins en partie de cette mobilité trop importante des atomes. Ce dépôt basse température permet ainsi de préserver une section rectangulaire par exemple du cœur du guide d'onde. Il évite l'apparition de facettes et l'altération des surfaces libres liée à une redistribution de matière du cœur.

Pour augmenter la vitesse de dépôt du matériau de gaine autour du cœur, de manière à rendre le procédé compatible avec une production industrielle, le dépôt de la coquille « basse température » est suivi par un dépôt « haute température » de la couche d'encapsulation, à une température $T_{épitaxie\ encapsulation}$ significativement plus élevée que la température de dépôt de la coquille $T_{épitaxie\ coquille}$.

Par exemple, la température de dépôt par épitaxie de la couche d'encapsulation $T_{épitaxie\ encapsulation}$ est supérieure ou égale à 830°C et de préférence supérieure ou égale à 850°C, de manière à bénéficier de vitesses de dépôt élevées.

La coquille, étant moins riche en germanium que le cœur, est plus robuste que le cœur vis-à-vis de ce dépôt « haute température ». Le cœur est ainsi protégé par la coquille lors de la formation de la gaine de forte épaisseur.

Dès lors, la gaine comprend en partie la coquille et la couche d'encapsulation.

Selon une possibilité avantageuse, la teneur en germanium de la couche d'encapsulation est inférieure ou égale à la teneur en germanium de la coquille, ceci afin d'améliorer le confinement du mode optique dans le guide d'onde.

Par ailleurs, ces teneurs en germanium sont de préférence inférieures à 80% de la teneur en germanium du cœur, et de préférence inférieures à 50% de la teneur en germanium du cœur, de manière à obtenir un bon contraste d'indices optiques entre le cœur et la gaine du guide d'onde.

Un aspect non couvert par les revendications concerne une utilisation d'un guide d'onde dans lequel la couche à base de germanium (Ge) est une couche de silicium-germanium (SiGe), ledit guide d'onde étant utilisé pour propager un flux lumineux dont la longueur d'onde est comprise entre 2 $\mu$m et 9 $\mu$m et de préférence entre 3 $\mu$m et 8 $\mu$m.

Cet aspect concerne en outre une utilisation d'un guide d'onde dans lequel la couche à base de germanium (Ge) est une couche de germanium (Ge), ledit guide d'onde étant utilisé pour propager un flux lumineux dont la longueur d'onde est comprise entre 7 $\mu$m et 16 $\mu$m et de préférence entre 8 $\mu$m et 15 $\mu$m.

Un aspect non couvert par les revendications concerne un guide d'onde comprenant un cœur et une gaine dans lequel le cœur est en un matériau à base de germanium (Ge) et la gaine est en un matériau à base de silicium (Si). Avantageusement, la gaine comprend une coquille entourant au moins partiellement le cœur, et une couche d'encapsulation entourant au moins partiellement la coquille, ladite coquille présentant une teneur en Ge $t_{Ge\ coquille}$ et une épaisseur $e_{coquille}$, et ladite couche d'encapsulation présentant une teneur en Ge $t_{Ge\ encapsulation}$ et une épaisseur $e_{encapsulation}$ telles que :

$$t_{Ge\ coquille} \approx t_{Ge\ encapsulation}\ et\ e_{coquille} \leq 0.1^* e_{encapsulation},$$

$$de\ préférence\ e_{coquille} \leq 0.05^* e_{encapsulation}.$$

BRÈVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :

- La FIGURE 1 montre une coupe transverse d'un guide d'onde en cours de réalisation selon un procédé de réalisation de l'art antérieur ;
- La FIGURE 2 montre une image de microscopie électronique à balayage d'un guide d'onde en cours de réalisation selon un procédé de réalisation de l'art antérieur ;
- La FIGURE 3a montre une première image de microscopie électronique à balayage d'un guide d'onde présentant des défauts structurels et réalisé selon un procédé de réalisation de l'art antérieur ;
- La FIGURE 3b montre une deuxième image de microscopie électronique à balayage - à un grandissement supérieur à celui de la première image en figure 3a - d'un guide d'onde présentant des défauts structurels et réalisé selon un procédé de réalisation de l'art antérieur ;
- La FIGURE 4 montre un diagramme de procédé illustrant des exemples de procédés de réalisation d'un guide d'onde selon un premier mode et un deuxième mode de réalisation de l'invention ;
- Les FIGURES 5a à 5e illustrent différentes étapes d'un procédé de réalisation d'un guide d'onde selon un premier mode de réalisation de l'invention ;
- Les FIGURES 6a à 6f illustrent différentes étapes d'un procédé de réalisation d'un guide d'onde selon un deuxième mode de réalisation de l'invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs relatives des différentes couches et films ne sont pas représentatives de la réalité.

DESCRIPTION DÉTAILLÉE DE L'INVENTION

Avant d'entamer une revue détaillée de modes de réalisation de l'invention, sont énoncées ci-après des caractéristiques optionnelles qui peuvent éventuellement être utilisées en association ou alternativement :
Selon un mode de réalisation particulièrement avantageux pour la réalisation de guides d'onde optimisés pour des flux lumineux présentant des longueurs d'onde comprises entre 3 $\mu$m et 8 $\mu$m (bande MIR 3-8$\mu$m), le procédé peut comprendre les caractéristiques optionnelles qui peuvent éventuellement être utilisées en association ou alternativement:

- la couche à base de Ge est une couche de silicium-germanium (SiGe).
- la couche à base de Ge présente une épaisseur $e_{coeur}$ comprise entre 1 et 4 $\mu$m, l'épaisseur $e_{coeur}$ étant prise selon une direction perpendiculaire au plan principal dans lequel s'étend le substrat.
- la couche à base de Ge présente une teneur en germanium sensiblement constante le long de l'épaisseur $e_{coeur}$ et comprise entre 20% et 50%.
- alternativement à la caractéristique précédente, la couche à base de Ge présente une teneur en germanium variant le long d'une direction perpendiculaire au plan principal dans lequel s'étend le substrat, selon un profil de concentration, ledit profil de concentration présentant un maximum compris entre 30% et 50%, et un minimum compris entre 0% et 5%. Le profil de concentration peut être par exemple triangulaire.
- la couche d'encapsulation et la coquille sont en silicium (Si).
- $T_{épitaxie\ coquille} \leq 750°C$.

- $T_{\text{épitaxie encapsulation}} \leq 1000°C$.
- de préférence, les deux caractéristiques précédentes sont combinées :
  $T_{\text{épitaxie coquille}} \leq 750°C$ et $T_{\text{épitaxie encapsulation}} \leq 1000°C$.

Ces températures de dépôt relatives à une coquille et une couche d'encapsulation en Si contribuent à éviter le facettage des surfaces libres du cœur en SiGe et à limiter la redistribution de matière lors de la formation de la gaine.

- le dépôt par épitaxie de la coquille est basé sur une chimie à base d'un précurseur gazeux $Si_nH_{2n+2}$, n étant un entier, ou $SiH_2Cl_2$.

Une chimie $SiH_4$ permet notamment d'obtenir des vitesses de croissance élevées à relativement basse température d'épitaxie. Une telle chimie permet donc d'améliorer un rendement du procédé de réalisation des guides d'onde. Une chimie chlorée $SiH_2Cl_2$, éventuellement avec ajout d'HCl, permet d'éviter un trop fort encrassement des parois d'une chambre de dépôt par épitaxie lors de dépôts de fortes épaisseurs.

- le dépôt par épitaxie de la coquille est effectué à une pression comprise entre 10 Torr et 100 Torr, et de préférence sensiblement égale à 20 Torr.

Une telle pression lors du dépôt permet d'éviter une éventuelle nucléation en phase gazeuse génératrice de défauts cristallins dans les couches déposées.

- la coquille en Si présente une épaisseur $e_{\text{coquille}}$ comprise entre 50nm et 100nm, l'épaisseur $e_{\text{coquille}}$ étant prise au droit du cœur et selon une direction perpendiculaire au plan principal dans lequel s'étend le substrat.

Cette gamme d'épaisseur de coquille Si offre une protection du cœur SiGe suffisante tout en évitant d'avoir une étape de dépôt trop longue.
Selon un mode de réalisation alternatif au précédent mode de réalisation, et particulièrement avantageux pour la réalisation de guides d'onde optimisés pour des flux lumineux présentant des longueurs d'onde comprises entre 8 $\mu$m et 15 $\mu$m (bande MIR 8-15$\mu$m), le procédé peut comprendre les caractéristiques optionnelles qui peuvent éventuellement être utilisées en association ou alternativement:

- la couche à base de germanium présente une teneur en germanium strictement supérieure à 50%. Cette couche peut être une couche en silicium-germanium ou une couche en germanium et présente de préférence une teneur en germanium supérieure à 95%.
- le procédé comprend en outre avant l'étape de dépôt de la couche à base de Ge, au moins l'étape suivante :
  ∘ Déposer au moins une couche tampon en silicium-germanium présentant une teneur en germanium comprise entre 20 % et 40 %.
- La couche d'encapsulation et la coquille sont en silicium-germanium (SiGe), les teneurs en germanium dans ladite coquille et ladite couche d'encapsulation étant comprises entre 20 % et 40 %.
- $T_{\text{épitaxie coquille}} \leq 650°C$ et $T_{\text{épitaxie encapsulation}} \leq 850°C$.

Ces températures de dépôt relatives à une coquille et une couche d'encapsulation en SiGe contribuent à éviter le facettage des surfaces libres du cœur en Ge et à limiter la redistribution de matière lors de la formation de la gaine.

- Le dépôt par épitaxie de la coquille est basé sur une chimie à base de précurseurs gazeux $Si_nH_{2n+2} + Ge_mH_{2m+2}$ n et m étant des entiers, ou $SiH_2Cl_2 + GeH_4$.
- La coquille présente une épaisseur $e_{\text{coquille}}$ comprise entre 100nm et 500nm.

Cette gamme d'épaisseur de coquille SiGe offre une protection du cœur Ge suffisante tout en évitant d'avoir une étape de dépôt trop longue.
Selon un mode de réalisation avantageux compatible avec les précédents modes de réalisation, mais uniquement optionnel :

- le procédé de réalisation comprend en outre, après l'étape de formation du cœur et avant l'étape de dépôt par épitaxie de la coquille, une étape de recuit, ledit recuit étant effectué à une température $T_{\text{recuit}}$, telle que $T_{\text{recuit}} \leq 1.1 *T_{\text{épitaxie coquille}}$ et de préférence $T_{\text{recuit}} \leq T_{\text{épitaxie coquille}}$.

Ce recuit destiné à éliminer une contamination résiduelle en carbone, fluor et oxygène avant l'épitaxie de la coquille, est avantageusement mené à « basse température » de manière à préserver le cœur d'une altération de ses surfaces libres.

- l'étape de recuit est effectuée de préférence sous hydrogène ($H_2$).
- alternativement, l'étape de recuit est effectuée sous gaz neutre, par exemple sous azote ($N_2$), sous argon (Ar) ou sous hélium (He).
- l'étape de recuit est effectuée à une pression comprise entre 10 Torr et 100 Torr, et de préférence sensiblement égale à 20 Torr.

Selon un mode de réalisation particulièrement avantageux et compatible avec les précédents modes de réalisation :

- $T_{\text{épitaxie encapsulation}} \geq 830°C$ et de préférence $T_{\text{épitaxie encapsulation}} \geq 850°C$.

Une telle température de dépôt de la couche d'encapsulation permet des vitesses de croissance élevées (> 100 nm.min$^{-1}$) compatibles avec un procédé de fabrication industriel.

- la température de dépôt de la couche d'encapsulation $T_{\text{épitaxie encapsulation}}$ est inférieure à la température de fusion du cœur.
- $t_{\text{Ge coquille}} \approx t_{\text{Ge encapsulation}}$.

La gaine peut ainsi présenter une homogénéité de composition.

- $t_{\text{Ge encapsulation}} \leq 0{,}8\ t_{\text{Ge coeur}}$ et de préférence $t_{\text{Ge encapsulation}} \leq 0{,}5\ t_{\text{Ge coeur}}$.

Le contraste d'indices optiques entre le cœur et la gaine peut ainsi être suffisamment élevé pour confiner très majoritairement le flux lumineux dans le cœur du guide d'onde.

- le procédé comprend une étape de montée en température entre l'étape de dépôt par épitaxie de la coquille et l'étape de dépôt de la couche d'encapsulation, ladite étape de montée en température étant réalisée de préférence sous hydrogène ($H_2$), à une vitesse de l'ordre de 2.5°C/s. Alternativement, cette étape de montée en température est réalisée sous gaz neutre, par exemple sous azote ($N_2$), sous argon (Ar) ou sous hélium (He).

Une telle vitesse permet de mieux contrôler une rampe de montée en température de manière à ne pas dépasser significativement la température cible $T_{\text{épitaxie encapsulation}}$.

- le procédé comprend au moins une étape de cyclage thermique court après le dépôt de la couche à base de germanium (Ge) sur le substrat, ledit cyclage thermique étant effectué à des températures comprises entre 750°C et 890°C, de préférence sous $H_2$.

Un cyclage thermique court permet de réduire avantageusement une densité de dislocations présentes au sein de la couche à base de germanium.

- la gaine est entièrement formée par la coquille, par la couche encapsulation et par la couche sur laquelle repose le cœur (le substrat par exemple). La coquille enveloppe toutes les faces du cœur qui ne sont pas au contact ou au regard du substrat. La couche d'encapsulation enveloppe toutes les faces de la coquille qui ne sont pas au contact ou au regard du substrat.
- la coquille est directement au contact du cœur.
- la couche d'encapsulation est directement au contact de la coquille.
- le cœur présente une dimension principale d'extension D, telle que $D \geq 2\ \mu m$, selon une section perpendiculaire à une direction principale de propagation d'un flux lumineux se propageant au sein dudit cœur.

Il est précisé que, dans le cadre de la présente invention, le dépôt d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

On entend par un substrat, un film, une couche, « à base » d'un matériau A, un substrat, un film, une couche comprenant ce matériau A uniquement ou ce matériau A et éventuellement d'autres matériaux, par exemple des éléments d'alliage, des impuretés ou des éléments dopants. Ainsi, une couche en un matériau à base de germanium (Ge) peut par exemple être une couche de germanium (Ge) ou une couche de silicium-germanium (SiGe).

En particulier, on entend par couche de germanium ou couche en germanium une couche comprenant majoritairement du germanium, et présentant de préférence une teneur en germanium supérieure à 95%.

Dans la présente demande de brevet, l'épaisseur est prise selon une direction perpendiculaire aux faces principales du substrat sur lequel repose les différentes couches. Sur les figures, l'épaisseur est prise selon la verticale. En particulier, dans la présente invention, la hauteur du cœur est sensiblement égale à l'épaisseur de la couche à partir de laquelle est formé ledit cœur.

On entend par dimension d'extension principale une dimension caractéristique. Dans la présente invention, si le cœur présente une section rectangulaire, la dimension principale d'extension D correspond à la longueur du plus grand côté de cette section rectangulaire. Si le cœur présente une section carrée, la dimension principale d'extension D correspond à la longueur des côtés du carré. Si le cœur présente une section circulaire, la dimension principale d'extension D correspond au diamètre.

Dans le cadre de la présente invention, les termes « concentration » et « teneur » sont utilisés indifféremment. On appelle teneur en une espèce ou en un élément sa fraction molaire ou sa fraction atomique dans un échantillon.

On notera ici en particulier que les teneurs en germanium mentionnées pour les alliages SiGe sont exprimés en % at. Ces pourcentages atomiques peuvent être mesurés à l'aide des méthodes suivantes bien connues telles que :

- EDX ou X-EDS acronyme de « energy dispersive x-ray spectroscopy » qui signifie « analyse dispersive en énergie de photons X ».

Cette méthode est bien adaptée pour analyser la composition de dispositifs de petites tailles telles que des guides d'onde comprenant un cœur et une gaine formée de plusieurs couches dont une couche dénommée coquille de faible épaisseur. Elle peut être mise en œuvre sur des coupes métallurgiques au sein d'un Microscope Electronique à Balayage (MEB) ou sur des lames minces au sein d'un Microscope Electronique en Transmission (MET ou TEM pour l'acronyme anglais de « Transmission Electron Microscopy »).

- SIMS, acronyme de « Secondary Ion Mass Spectroscopy » qui signifie « Spectroscopie de Masse à Ionisation Secondaire ».

Cette méthode permet d'accéder à la composition élémentaire des couches. Une zone de l'échantillon est pulvérisée par des ions primaires engendrant une ionisation secondaire caractéristique des éléments pulvérisés, et quantifiable via un spectromètre de masse. En particulier, pour un guide d'onde réalisé à partir d'un procédé selon l'invention, cette méthode pourrait mettre en évidence un pic interfacial de contamination en C, O et F entre le cœur et la gaine. Cette méthode pourrait également mettre en évidence un saut de concentration en Ge au sein de la gaine, entre une coquille SiGe et une couche d'encapsulation SiGe entourant cette coquille. Ce saut se caractérise par exemple par une différence de concentration en Ge d'au moins 5% et de préférence d'au moins 10% et de préférence d'au moins 20%.

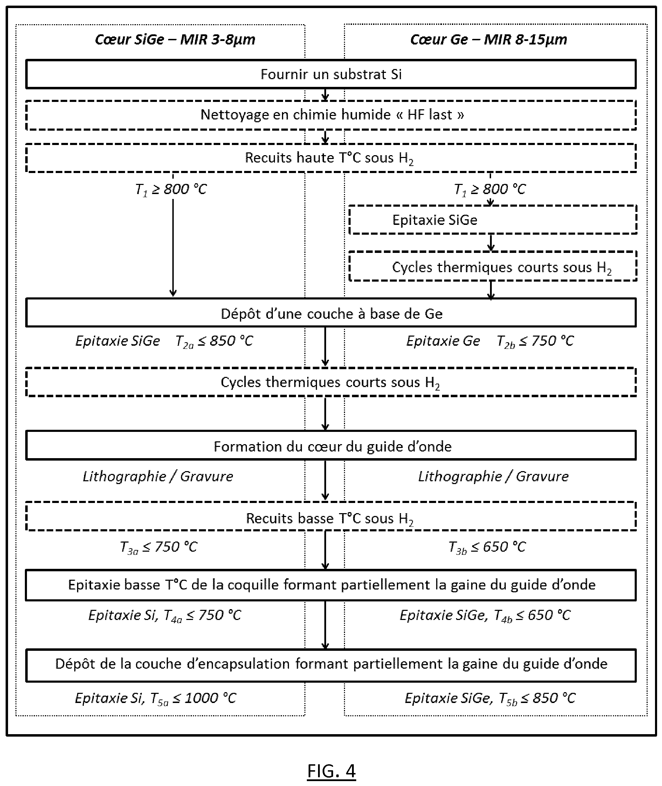

En référence à la figure 4, le procédé 100 de réalisation selon l'invention comprend une série d'étapes génériques 110, 210, 310, 410, 510 destinées à être mises en œuvre successivement pour réaliser un guide d'onde configuré pour guider un flux lumineux appartenant au spectre du moyen infrarouge.

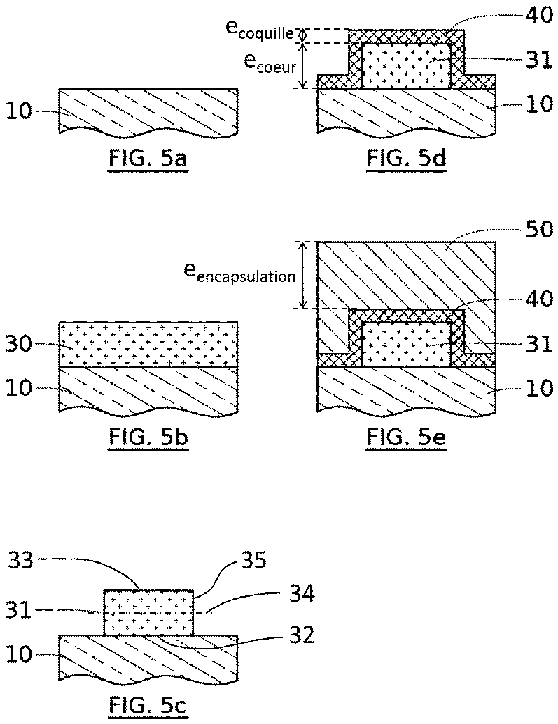

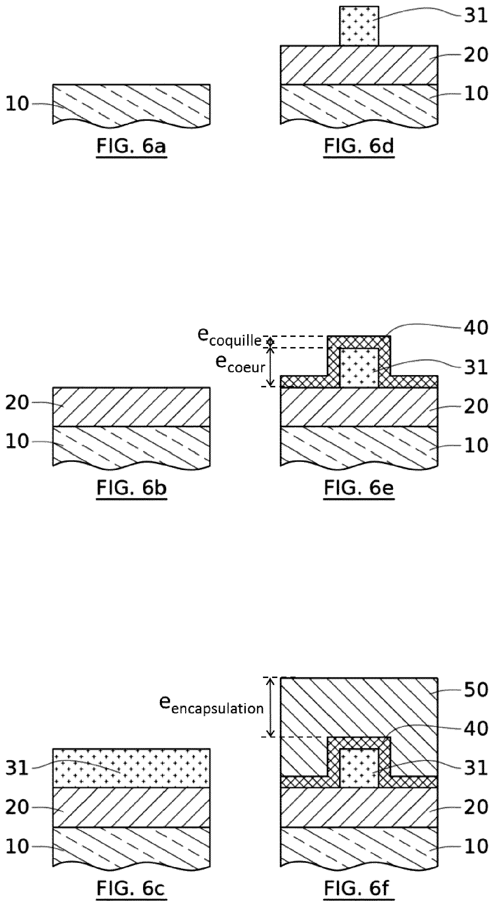

Dans cet exemple, la direction de propagation du flux lumineux est perpendiculaire à la section du cœur illustrée sur les figures 5c-5e et 6d-6f.

Une première étape consiste à fournir 110 un substrat.

Ce substrat est de préférence un substrat en silicium (Si) de diamètre 200mm ou 300mm. Ce substrat peut être alternativement un substrat SOI (Silicon On Insulator).

De préférence, ce substrat est préparé en vue d'étapes ultérieures de dépôt 210, 120 par épitaxie de couches à base de germanium.

Des étapes de préparation, telles qu'une étape de nettoyage 111 suivie d'une étape de recuit 112 sont de préférence mises en œuvre sur le substrat.

L'étape de nettoyage 111 comprend de préférence un nettoyage en chimie humide de type « HF last », à base d'une solution d'acide fluorhydrique (HF), de manière à éliminer une couche d'oxyde native sur le substrat.

L'étape de recuit 112 vise à éliminer une contamination résiduelle en éléments carbone, oxygène et fluor résultant de l'étape de nettoyage 111 précédente, de manière à fournir un substrat présentant une surface de silicium adaptée aux dépôts 210, 120 par épitaxie, également dénommé croissance par épitaxie ou simplement épitaxie, de couches à base de germanium. Cette étape de recuit 112 est réalisée à une température $T_1$ telle que $800°C \leq T_1 \leq 1100°C$ pour un substrat Si en particulier. De préférence pour un substrat SOI ou pour un substrat Si présentant une couche SiGe en surface cette température sera plus faible, par exemple $800°C \leq T_1 \leq 900°C$. Cette température plus faible permet de réduire les risques de démouillage de la couche supérieure en Si du substrat SOI, l'apparition de lignes de glissement dues à des inhomogénéités de température en surface de la plaque SOI ou encore une ondulation trop forte de la surface de SiGe. Cette étape de recuit 112 est de préférence réalisée sous flux d'hydrogène ($H_2$) à une pression de l'ordre de 20 Torr pendant 2 min environ.

Le procédé 100 comprend, suite à ces étapes de fourniture 110 du substrat, de nettoyage 111 et de recuit 112, une étape de dépôt 210 pour former une couche à base de germanium.

Cette étape de dépôt 210 est de préférence réalisée par épitaxie, et les paramètres de ce dépôt 210 dépendent notamment de la teneur souhaitée en germanium dans ladite couche à base de germanium.

Une étape de formation 310 du cœur du guide d'onde est ensuite réalisée selon des procédés classiques de lithographie et de gravure, à partir de la couche à base de germanium.

Avantageusement, on effectue une étape de dépôt 410 par épitaxie d'une coquille sur le cœur du guide d'onde. Cette étape de dépôt 410 par épitaxie est réalisée à « basse température », c'est-à-dire à une température suffisamment basse pour éviter une dégradation du cœur. Cette coquille permet notamment de protéger le cœur vis-à-vis de l'étape suivante.

L'étape suivante comprend le dépôt 510, de préférence par épitaxie, d'une couche d'encapsulation sur la coquille. Ce dépôt 510 se fait de préférence à une température plus élevée que la température à laquelle se fait le dépôt 410 formant la coquille.

Les paramètres de ces différentes étapes génériques 110, 210, 310, 410, 510 peuvent être adaptés de manière à décliner différents modes de réalisation du procédé 100.

Deux modes de réalisation, particulièrement avantageux mais non limitatifs vont maintenant être décrits en détail.

Un premier mode de réalisation du procédé 100, illustré par les figures 5a à 5e, concerne un procédé 100a de réalisation d'un guide d'onde comprenant un cœur 31 en SiGe et une gaine en Si.

Après fourniture 110, nettoyage 111 et recuit 112 d'un substrat 10 en silicium, l'étape de dépôt 210 de la couche 30 à base de germanium est paramétrée de sorte à ce que ladite couche 30 présente une épaisseur de 2 à 3 $\mu$m, et soit de préférence composée d'un alliage SiGe présentant une teneur en Ge comprise entre 20% et 50%.

Cette couche 30 à base de germanium peut présenter une composition sensiblement constante dans son épaisseur ; alternativement, au moins un gradient de composition peut être réalisé le long de l'épaisseur de cette couche 30. Par exemple, la couche 30 peut présenter une teneur en Ge variant dans son épaisseur selon un profil triangulaire. La couche 30 peut présenter une teneur en germanium $t_{Ge}$ minimale de quelques pourcents atomiques, typiquement $t_{Ge} \leq 5\%$ at, au niveau d'une interface 32 avec le substrat 10 Si et au niveau d'une face 33 supérieure opposée à cette interface 32, et une teneur en germanium $t_{Ge}$ maximale de l'ordre de 40% at au niveau d'un plan médian 34 situé entre ladite interface 32 et ladite face 33 supérieure.

Le dépôt 210 est de préférence réalisé par épitaxie à partir d'une chimie basée sur des précurseurs dichlorosilane $SiH_2Cl_2$ et germane $GeH_4$, ou sur des précurseurs silane $SiH_4$ et germane $GeH_4$, en phase gazeuse, à une température $T_{2a}$ telle que $850°C \leq T_{2a} \leq 900°C$, et à une pression de l'ordre de 20 Torr.

Cette température $T_{2a}$ permet notamment de bénéficier de vitesses de croissance élevées pour cette couche 30, compatibles avec un dépôt de forte épaisseur. Une telle température $T_{2a}$ permet également de répartir plus uniformément les dislocations présentes au sein de cette couche 30 grâce à une plus grande mobilité desdites dislocations, et de minimiser potentiellement leur densité par recombinaison/annihilation de dislocations.

Après dépôt 210, une étape de cyclage thermique 211 sous $H_2$ à des températures variant entre 850°C et 1000°C sur des cycles courts de quelques minutes peut avantageusement permettre de réduire la densité de dislocations émergentes dans la couche 30.

L'étape de formation 310 du cœur 31 est réalisée à partir de ladite couche 30 par des procédés standards de photolithographie et de gravure.

En particulier, un procédé de gravure sèche de type gravure ionique réactive profonde peut être mis en œuvre afin d'obtenir des parois verticales pour le cœur 31 sur une épaisseur de 2 à 3 $\mu$m.

Ce cœur 31 en SiGe est de préférence gainé par une gaine en silicium de forte épaisseur, typiquement comprise entre 6 $\mu$m et 12 $\mu$m, de manière à réaliser un guide d'onde MIR configuré pour confiner un flux lumineux présentant une longueur d'onde comprise entre 3 $\mu$m et 8 $\mu$m.

Préalablement à la formation de cette gaine, un deuxième recuit 320 peut être effectué à une température $T_{3a}$ sensiblement égale à 750°C, sous flux d'hydrogène ($H_2$) à une pression de l'ordre de 20 Torr pendant 2 min environ.

Ce deuxième recuit 320 permet d'éliminer au moins partiellement une contamination résiduelle issue de l'étape de gravure précédente tout en évitant d'altérer les surfaces libres du cœur 31, et préservant dès lors une verticalité des parois et une section par exemple rectangulaire du cœur 31.

Une fine coquille 40 de silicium est ensuite avantageusement formée sur le cœur 31 lors d'une étape de dépôt 410 par épitaxie.

Ce dépôt 410 de la coquille 40 en silicium est de préférence réalisé à une température $T_{4a}$ sensiblement égale

à 750°C de manière à éviter ou limiter une dégradation des surfaces libres du cœur 31.

Ce dépôt 410 est réalisé de préférence par épitaxie à partir d'une chimie basée sur un précurseur silane $SiH_4$, ou dichlorosilane $SiH_2Cl_2$, en phase gazeuse à une pression comprise entre 10 Torr et 100 Torr, de préférence sensiblement égale à 20 Torr. La chimie silane $SiH_4$ présente des vitesses de croissance plus élevées que la chimie dichlorosilane pour cette température $T_{4a}$, et peut avantageusement améliorer le rendement de ce dépôt 410 de la coquille 40 en Si.

La coquille 40 de silicium présente une épaisseur comprise entre 50 nm et 150 nm de préférence, de manière à protéger avantageusement le cœur 31 vis-à-vis de l'étape subséquente de dépôt 510 de la couche d'encapsulation 50 en silicium.

Cette étape de dépôt 510 est en effet réalisée à plus haute température, typiquement à une température $T_{5a}$ comprise entre 850°C et 1000°C, de manière à augmenter la vitesse de croissance de la couche d'encapsulation 50 pour déposer plus rapidement une forte épaisseur de matériau.

Une chimie chlorée basée sur un précurseur dichlorosilane $SiH_2Cl_2$ et un ajout d'acide chlorhydrique HCl en phase gazeuse peut avantageusement permettre d'éviter un trop fort encrassement des parois de la chambre de dépôt lors de cette étape de dépôt 510 visant à former la couche d'encapsulation 50.

Une rampe de montée en température de l'ordre de 2.5°C/s sous flux d'hydrogène $H_2$ peut avantageusement permettre d'atteindre la température $T_{5a}$ à partir de la température $T_{4a}$ avec un contrôle suffisamment fin pour ne pas dépasser excessivement ladite température $T_{5a}$.

La couche d'encapsulation 50, la coquille 40 et le substrat 10 forment ainsi la gaine en silicium entourant le cœur 31 en silicium-germanium du guide d'onde MIR. De préférence, la coquille 40 enveloppe toutes les faces du cœur 31 qui ne sont pas au contact ou au regard du substrat 10. Dans cet exemple la coquille 40 recouvre ainsi les flancs 35 et toute la face 33 supérieure du cœur 31. De même, la couche d'encapsulation 50 enveloppe toutes les faces de la coquille 40 qui ne sont pas au contact ou au regard du cœur 31.

Une température $T_{5a} \leq 1000°C$ permet en outre de limiter une interdiffusion des éléments Si et Ge entre le cœur 31 en SiGe et la coquille 40 en Si. Une interdiffusion trop importante de ces éléments est en effet préjudiciable au bon contraste d'indices optiques et par conséquent au bon confinement d'un mode optique d'un flux lumineux au sein d'un tel guide d'onde.

Un deuxième mode de réalisation du procédé 100, illustré par les figures 6a à 6f, concerne un procédé 100b de réalisation d'un guide d'onde comprenant un cœur 31 en Ge et une gaine en SiGe.

Seules les caractéristiques distinctes du premier mode de réalisation sont décrites ci-après, les autres caractéristiques non décrites étant réputées identiques à celles du premier mode de réalisation décrit en référence aux figures 5a à 5e.

Optionnellement, une épitaxie 120 d'une couche tampon 20 est réalisée préalablement à l'étape de dépôt 210 de la couche 30 à base de germanium. Cette couche tampon 20 est de préférence en un alliage de SiGe présentant une teneur en Ge comprise entre 20% et 40% et une épaisseur supérieure ou égale à 6 $\mu$m.

Cette épitaxie 120 préalable peut se faire à une température comprise entre 850°C et 900°C, à partir d'une chimie $SiH_2Cl_2$ et $GeH_4$ par exemple.

Une étape consécutive de cyclage thermique 121 sous $H_2$ à des températures variant entre 750°C et 890°C sur des cycles courts de quelques minutes peut avantageusement permettre de réduire la densité de dislocations émergentes dans la couche tampon 20.

L'étape de dépôt 210 de la couche 30 à base de germanium est dès lors paramétrée de sorte à ce que cette couche 30 présente une épaisseur de 2 à 3 $\mu$m, et soit de préférence composée de Ge, de préférence d'au moins 90% de Ge et de préférence de 100% de Ge. Cette couche 30 peut présenter des impuretés, par exemple de Si, dans des teneurs faibles, typiquement comprises entre quelques dixièmes de pourcents atomiques et quelques pourcents atomiques.

Ce dépôt 210 de la couche 30 est de préférence réalisé par épitaxie à partir d'une chimie basée sur un précurseur germane $GeH_4$ en phase gazeuse, par exemple à une température $T_{2b}$ de l'ordre de 400°C et à une pression de l'ordre de 100 Torr pendant une durée comprise entre 6 min et 10 min, puis à la température $T_{2b}$ de l'ordre de 750°C et à une pression de l'ordre de 20 Torr pendant une durée comprise entre 35 min et 55 min.

L'étape de formation 310 du cœur 31 est réalisée à partir de ladite couche 30 en germanium (Ge) par des procédés standards de photolithographie et de gravure.

Ce cœur 31 en Ge est de préférence gainé par une gaine en SiGe de forte épaisseur, typiquement comprise entre 6 $\mu$m et 12 $\mu$m, de manière à réaliser un guide d'onde MIR configuré pour confiner un flux lumineux présentant une longueur d'onde comprise entre 8 $\mu$m et 15 $\mu$m.

Préalablement à la formation de cette gaine, le deuxième recuit 320 peut être effectué à une température $T_{3b}$ sensiblement égale à 650°C, sous flux d'hydrogène ($H_2$) à une pression de l'ordre de 20 Torr pendant 2 min environ.

Ce deuxième recuit 320 permet d'éliminer au moins partiellement une contamination résiduelle issue de l'étape précédente tout en évitant d'altérer les surfaces libres du cœur 31 en Ge, préservant dès lors une verticalité des parois et une section par exemple rectangulaire dudit cœur 31 en Ge.

Une fine coquille 40 de silicium-germanium est ensuite avantageusement formée sur le cœur 31 en Ge lors d'une étape de dépôt 410 par épitaxie.

Ce dépôt 410 de la coquille 40 en SiGe est de préférence réalisé à une température $T_{4b}$ sensiblement égale à 650°C, ou comprise entre 550°C et 650°C, de manière à éviter ou limiter une dégradation des surfaces libres du cœur 31 en Ge.

Ce dépôt 410 est réalisé de préférence par épitaxie à partir d'une chimie basée sur des précurseurs dichlorosilane $SiH_2Cl_2$ et germane $GeH_4$, ou sur des précurseurs silane $SiH_4$ et germane $GeH_4$, en phase gazeuse à une pression comprise entre 10 Torr et 100 Torr, de préférence sensiblement égale à 20 Torr.

La coquille 40 de silicium-germanium présente une épaisseur comprise entre 100 nm et 500 nm de manière à protéger le cœur 31 en Ge vis-à-vis de l'étape de dépôt 510 d'une couche d'encapsulation 50 en silicium-germanium.

Cette étape de dépôt 510 de la couche d'encapsulation 50 est en effet réalisée à plus haute température, typiquement à une température $T_{5b}$ inférieure ou égale à 850°C, de manière à augmenter la vitesse de croissance de la couche d'encapsulation 50 pour déposer plus rapidement une forte épaisseur de matériau.

La couche d'encapsulation 50, la coquille 40 et de préférence la couche tampon 20 forment ainsi la gaine en SiGe entourant le cœur 31 en Ge du guide d'onde MIR.

Au vu de la description qui précède, il apparaît clairement que l'invention propose un procédé particulièrement fiable et efficace pour réaliser, avec un rendement industriel, des guides d'onde dont les performances ne sont pas altérées.

L'invention n'est pas limitée aux modes de réalisations précédemment décrits et s'étend à tous les modes de réalisation couverts par les revendications.

**Revendications**

1. Procédé (100) de réalisation d'un guide d'onde comprenant au moins un cœur (31) et une gaine, le procédé (100) comprenant au moins les étapes suivantes:

   - Fournir (110) un substrat (10),
   - Déposer (210) une couche à base de germanium (Ge) (30) sur le substrat (10),
   - Former (310) le cœur (31) du guide d'onde dans ladite couche à base de Ge (30),
   - Déposer (510) une couche d'encapsulation (50) autour du cœur (31), la couche d'encapsulation (50) présentant une teneur en germanium $t_{Ge\ encapsulation}$ nulle ou telle que :
   $t_{Ge\ encapsulation} \leq 0{,}9\ t_{Ge\ coeur}$,
   $t_{Ge\ coeur}$ étant la teneur en germanium du cœur (31), de manière à former au moins partiellement la gaine,

   le procédé (100) étant **caractérisé en ce que**, avant l'étape de dépôt (510) de la couche d'encapsulation (50), le procédé (100) comprend en outre au moins l'étape suivante :

   - Déposer (410) par épitaxie une coquille (40) autour du cœur (31), ladite coquille (40) formant au moins partiellement ladite gaine et présentant une teneur en germanium $t_{Ge\ coquille}$ nulle ou telle que :
   $t_{Ge\ coquille} \leq 0{,}9\ t_{Ge\ coeur}$,
   le dépôt (410) par épitaxie de la coquille (40) étant effectué à une température $T_{épitaxie\ coquille} \leq 780°C$, et
   **en ce que** ladite couche d'encapsulation (50) est déposée (510) par épitaxie à une température $T_{épitaxie\ encapsulation}$ telle que :
   $T_{épitaxie\ encapsulation} \geq 1{,}08 * T_{épitaxie\ coquille}$.

2. Procédé (100) de réalisation d'un guide d'onde selon la revendication précédente dans lequel $T_{épitaxie\ encapsulation} \geq 830°C$ et de préférence $T_{épitaxie\ encapsulation} \geq 850°C$.

3. Procédé (100) de réalisation d'un guide d'onde selon l'une quelconque des revendications précédentes dans lequel $t_{Ge\ coquille} \approx t_{Ge\ encapsulation}$ et $t_{Ge\ encapsulation} \leq 0{,}8\ t_{Ge\ coeur}$ et de préférence $t_{Ge\ encapsulation} \leq 0{,}5\ t_{Ge\ coeur}$.

4. Procédé (100) de réalisation d'un guide d'onde selon l'une quelconque des revendications précédentes comprenant, après l'étape de formation (310) par lithographie du cœur (31) et avant l'étape de dépôt (410) par épitaxie de la coquille (40), une étape de recuit (320), ledit recuit (320) étant effectué à une température $T_{recuit}$ telle que $T_{recuit} \leq 1.1 * T_{épitaxie\ coquille}$ et de préférence $T_{recuit} \leq T_{épitaxie\ coquille}$,
   et optionnellement dans lequel ladite étape de recuit (320) est effectuée sous gaz neutre, de préférence sous hydrogène (H2).

5. Procédé (100) de réalisation d'un guide d'onde selon l'une quelconque des revendications précédentes dans lequel le cœur (31) présente une dimension principale d'extension D, telle que $D \geq 2\ \mu m$, selon une section perpendiculaire à une direction principale de propagation d'un flux lumineux se propageant au sein dudit cœur (31).

6. Procédé (100) de réalisation d'un guide d'onde selon l'une quelconque des revendications précédentes dans lequel ladite couche à base de Ge (30) est une couche de silicium-germanium (SiGe) et optionnellement dans lequel ladite couche à base de Ge (30) présente une épaisseur $e_{coeur}$ comprise entre 1 et 4 $\mu m$, l'épaisseur $e_{coeur}$ étant prise selon une direction perpendiculaire au plan principal dans lequel s'étend le substrat (10).

7. Procédé (100) de réalisation d'un guide d'onde selon l'une quelconque des deux revendications précédentes dans lequel ladite couche à base de Ge (30) présente une teneur en germanium sensiblement constante le long de l'épaisseur $e_{coeur}$ et comprise entre 20% et 50%.

8. Procédé (100) de réalisation d'un guide d'onde selon l'une quelconque des revendications 1 à 6, dans lequel ladite couche à base de Ge (30) présente une teneur en germanium variant, le long d'une direction perpendiculaire au plan principal dans lequel s'étend le substrat (10), selon un profil de concentration, ledit profil de concentration présentant un maximum compris entre 30% et 50%, et un minimum compris entre 0% et 5%, et optionnellement dans lequel le profil de concentration est triangulaire.

9. Procédé (100) de réalisation d'un guide d'onde selon l'une quelconque des revendications 6 à 8, dans lequel la couche d'encapsulation (50) et la coquille (40) sont en silicium (Si).

10. Procédé (100) de réalisation d'un guide d'onde selon l'une quelconque des revendications 6 à 9, dans lequel la coquille (40) présente une épaisseur $e_{coquille}$ comprise entre 50nm et 100nm l'épaisseur $e_{coquille}$ étant prise au droit du cœur (31) et selon une direction perpendiculaire au plan principal dans lequel s'étend le substrat (10).

11. Procédé (100) de réalisation d'un guide d'onde selon l'une quelconque des revendications 6 à 10, dans lequel $T_{épitaxie\ coquille} \leq 750°C$ et dans lequel $T_{épitaxie\ encapsulation} \leq 1000°C$.

12. Procédé (100) de réalisation d'un guide d'onde selon l'une quelconque des revendications 1 à 5 dans lequel ladite couche à base de Ge (30) présente une teneur en Ge strictement supérieure à 50% et de préférence supérieure à 95%, et optionnellement le procédé comprenant en outre avant l'étape de dépôt (210) de la couche à base de Ge (30), au moins l'étape suivante :

   - Déposer (120) au moins une couche tampon (20) en silicium-germanium (SiGe) présentant une teneur en germanium comprise entre 20 % et 40 %.

13. Procédé (100) de réalisation d'un guide d'onde selon la revendication précédente dans lequel la couche d'encapsulation (50) et la coquille (40) sont en silicium-germanium (SiGe), les teneurs en germanium dans ladite coquille (40) et ladite couche d'encapsulation (50) étant comprises entre 20 % et 40 % et optionnellement dans lequel la coquille (40) présente une épaisseur $e_{coquille}$ comprise entre 100nm et 500nm.

14. Procédé (100) de réalisation d'un guide d'onde selon l'une quelconque des revendications 12 à 13 dans lequel $T_{épitaxie\ coquille} \leq 650°C$.

15. Procédé (100) de réalisation d'un guide d'onde selon l'une quelconque des revendications 12 à 14 dans lequel $T_{épitaxie\ encapsulation} \leq 850°C$.

**Patentansprüche**

1. Verfahren (100) zur Herstellung eines Wellenleiters, der mindestens einen Kern (31) und einen Mantel umfasst, wobei das Verfahren (100) mindestens die folgenden Schritte umfasst:

   - Bereitstellen (110) eines Substrats (10),
   - Abscheiden (210) einer Schicht auf Basis von Germanium (Ge) (30) auf dem Substrat (10),

- Bilden (310) des Kerns (31) des Wellenleiters in der Schicht auf Ge-Basis (30),
- Abscheiden (510) einer Verkapselungsschicht (50) um den Kern (31), wobei die Verkapselungsschicht (50) einen Germaniumgehalt $t_{Ge\ Verkapselung}$ von null oder derart aufweist, dass:

$t_{Ge\ Verkapselung} \leq 0,9\ t_{Ge\ Kern}$,

wobei es sich bei $t_{Ge\ Kern}$ um den Germaniumgehalt des Kerns (31) handelt, um mindestens teilweise den Mantel zu bilden, wobei das Verfahren (100) **dadurch gekennzeichnet ist, dass** das Verfahren (100) vor dem Schritt des Abscheidens (510) der Verkapselungsschicht (50) weiter mindestens den folgenden Schritt umfasst:
- epitaktisches Abscheiden (410) einer Hülle (40) um den Kern (31), wobei die Hülle (40) mindestens teilweise den Mantel bildet und einen Germaniumgehalt $t_{Ge\ Hülle}$ von null oder derart aufweist, dass:

$t_{Ge\ Hülle} \leq 0,9\ t_{Ge\ Kern}$,

wobei die epitaktische Abscheidung (410) der Hülle (40) bei einer Temperatur $T_{Epitaxie\ Hülle} \leq 780\ °C$ erfolgt, und dadurch, dass die Verkapselungsschicht (50) epitaktisch abgeschieden (510) wird bei einer Temperatur $T_{Epitaxie\ Verkapselung}$ derart, dass:

$T_{Epitaxie\ Verkapselung} \geq 1,08 * T_{Epitaxie\ Hülle}$.

2. Verfahren (100) zur Herstellung eines Wellenleiters nach dem vorstehenden Anspruch, wobei $T_{Epitaxie\ Verkapselung} \geq 830\ °C$, und vorzugsweise $T_{Epitaxie\ Verkapselung} \geq 850\ °C$.

3. Verfahren (100) zur Herstellung eines Wellenleiters nach einem der vorstehenden Ansprüche, wobei $t_{Ge\ Hülle} \approx t_{Ge\ Verkapselung}$ und $t_{Ge\ Verkapselung} \leq 0,8\ t_{Ge\ Kern}$, und vorzugsweise $t_{Ge\ Verkapselung} \leq 0,5\ t_{Ge\ Kern}$.

4. Verfahren (100) zur Herstellung eines Wellenleiters nach einem der vorstehenden Ansprüche, das nach dem Schritt des Bildens (310) des Kerns (31) mittels Lithographie, und vor dem Schritt des epitaktischen Abscheidens (410) der Hülle (40) einen Schritt des Anlassens (320) umfasst, wobei das Anlassen (320) bei einer Temperatur $T_{Anlass}$ erfolgt, derart, dass $T_{Anlass} \leq 1,1 * T_{Epitaxie\ Hülle}$, und vorzugsweise $T_{Anlass} \leq T_{Epitaxie\ Hülle}$, und wobei der Schritt des Anlassens (320) gegebenenfalls unter Neutralgas, vorzugsweise unter Wasserstoff (H2) erfolgt.

5. Verfahren (100) zur Herstellung eines Wellenleiters nach einem der vorstehenden Ansprüche, wobei der Kern (31) in einem Querschnitt senkrecht zu einer Hauptausbreitungsrichtung eines sich im Kern (31) ausbreitenden Lichtstroms eine Haupterstreckungsabmessung D aufweist, derart, dass $D \geq 2\ \mu m$.

6. Verfahren (100) zur Herstellung eines Wellenleiters nach einem der vorstehenden Ansprüche, wobei es sich bei der Schicht auf Ge-Basis (30) um eine Silicium-Germanium- (SiGe) Schicht handelt, und wobei die Schicht auf Ge-Basis (30) gegebenenfalls eine Dicke $e_{Kern}$ im Bereich zwischen 1 und 4 $\mu m$ aufweist, wobei die Dicke $e_{Kern}$ in einer Richtung senkrecht zur Hauptebene, in der sich das Substrat (10) erstreckt, ermittelt wird.

7. Verfahren (100) zur Herstellung eines Wellenleiters nach einem der zwei vorstehenden Ansprüche, wobei die Schicht auf Ge-Basis (30) einen Germaniumgehalt aufweist, der im Wesentlichen entlang der Dicke $e_{Kern}$ konstant ist und im Bereich zwischen 20 % und 50 % liegt.

8. Verfahren (100) zur Herstellung eines Wellenleiters nach einem der Ansprüche 1 bis 6, wobei die Schicht auf Ge-Basis (30) einen Germaniumgehalt aufweist, der entlang einer Richtung senkrecht zur Hauptebene, in der sich das Substrat (10) erstreckt, gemäß einem Konzentrationsprofil variiert, wobei das Konzentrationsprofil ein Maximum im Bereich zwischen 30 % und 50 %, und ein Minimum im Bereich zwischen 0 % und 5 % aufweist, und wobei das Konzentrationsprofil gegebenenfalls dreieckig ist.

9. Verfahren (100) zur Herstellung eines Wellenleiters nach einem der Ansprüche 6 bis 8, wobei die Verkapselungsschicht (50) und die Hülle (40) aus Silicium (Si) sind.

10. Verfahren (100) zur Herstellung eines Wellenleiters nach einem der Ansprüche 6 bis 9, wobei die Hülle (40) eine Dicke $e_{Hülle}$ im Bereich zwischen 50 nm und 100 nm aufweist, wobei die Dicke $e_{Hülle}$ am Kern (31) und in einer Richtung senkrecht zur Hauptebene, in der sich das Substrat (10) erstreckt, ermittelt wird.

11. Verfahren (100) zur Herstellung eines Wellenleiters nach einem der Ansprüche 6 bis 10, wobei $T_{Epitaxie\ Hülle} \leq 750\ °C$, und wobei $T_{Epitaxie\ Verkapselung} \leq 1000\ °C$.

12. Verfahren (100) zur Herstellung eines Wellenleiters nach einem der Ansprüche 1 bis 5, wobei die Schicht auf Ge-Basis (30) einen Ge-Gehalt von streng größer als 50 %, und vorzugsweise größer als 95 % aufweist, und wobei das Verfahren gegebenenfalls vor dem Schritt des Abscheidens (210) der Schicht auf Ge-Basis (30) weiter mindestens den folgenden Schritt umfasst:

- Abscheiden (120) mindestens einer Pufferschicht (20) aus Silicium-Germanium (SiGe), die einen Germaniumgehalt im Bereich zwischen 20 % und 40 % aufweist.

13. Verfahren (100) zur Herstellung eines Wellenleiters nach dem vorstehenden Anspruch, wobei die Verkapselungsschicht (50) und die Hülle (40) aus Silicium-Germanium (SiGe) sind, wobei die Germaniumgehalte in der Hülle (40) und der Verkapselungsschicht (50) im Bereich zwischen 20 % und 40 % liegen, und wobei die Hülle (40) gegebenenfalls eine Dicke $e_{\text{Hülle}}$ im Bereich zwischen 100 nm und 500 nm aufweist.

14. Verfahren (100) zur Herstellung eines Wellenleiters nach einem der Ansprüche 12 bis 13, wobei $T_{\text{Epitaxie Hülle}} \leq 650\,°C$.

15. Verfahren (100) zur Herstellung eines Wellenleiters nach einem der Ansprüche 12 bis 14, wobei $T_{\text{Epitaxie Verkapselung}} \leq 850\,°C$.


**Claims**

1. Method (100) for producing a waveguide comprising at least one core (31) and a sheath, the method (100) comprising at least the following steps:

   - Providing (110) a substrate (10),
   - Depositing (210) a layer based on germanium (Ge) (30) on the substrate (10),
   - Forming (310) the core (31) of the waveguide in said layer based on Ge (30),
   - Depositing (510) an encapsulation layer (50) around the core (31), the encapsulation layer (50) having a germanium content $t_{\text{Ge encapsulation}}$ nulle or such that:
   $t_{\text{Ge encapsulation}} \leq 0.9\ t_{\text{Ge core}}$,
   $t_{\text{Ge core}}$ being the germanium content of the core (31), so as to at least partially form the sheath,
   the method (100) being **characterised in that**, before the step of depositing (510) the encapsulation layer (50), the method (100) further comprises at least the following step:
   - Depositing (410) by epitaxy a shell (40) around the core (31), said shell (40) at least partially forming said sheath and having a germanium content $t_{\text{Ge shell}}$ nulle or such that:
   $t_{\text{Ge shell}} \leq 0.9\ t_{\text{Ge core}}$,
   the deposition (410) by epitaxy of the shell (40) being performed at a temperature $T_{\text{epitaxy shell}} \leq 780°C$, and
   and **in that** said encapsulation layer (50) is deposited (510) by epitaxy at a temperature $T_{\text{epitaxy encapsulation}}$ such that:
   $T_{\text{epitaxy encapsulation}} \geq 1.08 * T_{\text{epitaxy shell}}$.

2. Method (100) for producing a waveguide according to the preceding claim, wherein $T_{\text{epitaxy encapsulation}} \geq 830°C$ and preferably $T_{\text{epitaxy encapsulation}} \geq 850°C$.

3. Method (100) for producing a waveguide according to any one of the preceding claims, wherein $t_{\text{Ge shell}} \approx t_{\text{Ge encapsulation}}$ and $t_{\text{Ge encapsulation}} \leq 0.8\ t_{\text{Ge core}}$ and preferably $t_{\text{Ge encapsulation}} \leq 0.5\ t_{\text{Ge core}}$.

4. Method (100) for producing a waveguide according to any one of the preceding claims, comprising, after the step of formation (310) of the core (31) by lithography and before the step of deposition (410) of the shell (40) by epitaxy, an annealing step (320), said annealing (320) being performed at a temperature $T_{\text{annealing}}$ such that $T_{\text{annealing}} \leq 1.1 * T_{\text{epitaxy shell}}$ and preferably $T_{\text{annealing}} \leq T_{\text{epitaxy shell}}$,
   and optionally wherein said annealing step (320) is performed under a neutral gas, preferably under hydrogen ($H_2$).

5. Method (100) for producing a waveguide according to any one of the preceding claims, wherein the core (31) has a principal extension dimension D, such that $D \geq 2\ \mu m$, on a cross section perpendicular to a principal direction of propagation of a light flow propagating in said core (31).

6. Method (100) for producing a waveguide according to any one of the preceding claims, wherein said layer based on Ge (30) is a silicon-germanium (SiGe) layer and optionally wherein said layer based on Ge (30) has a thickness

$e_{core}$ of between 1 and 4 $\mu m$ , the thickness $e_{core}$ being taken in a direction perpendicular to the principal plane in which the substrate (10) extends.

7.  Method (100) for producing a waveguide according to either one of the preceding two claims, wherein said layer based on Ge (30) has a substantially constant germanium content across the thickness $e_{core}$ and between 20% and 50%.

8.  Method (100) for producing a waveguide according to any one of claims 1 to 6, wherein said layer based on Ge (30) has a germanium content varying, along a direction perpendicular to the principal plane in which the substrate (10) extends, according to a concentration profile, said concentration profile having a maximum of between 30% and 50%, and a minimum of between 0% and 5%, and optionally in which the concentration profile is triangular.

9.  Method (100) for producing a waveguide according to any one of claims 6 to 8, wherein the encapsulation layer (50) and the shell (40) are made from silicon (Si).

10. Method (100) for producing a waveguide according to any one of claims 6 to 9, wherein the shell (40) has a thickness $e_{shell}$ between 50 nm and 100 nm, the thickness $e_{shell}$ being taken in line with the core (31) and in a direction perpendicular to the principal plane in which the substrate (10) extends.

11. Method (100) for producing a waveguide according to any one of claims 6 to 10, wherein $T_{eptaxy\ shell} \leq 750°C$ and wherein $T_{epitaxy\ encapsulation} \geq 1000°C$.

12. Method (100) for producing a waveguide according to any one of claims 1 to 5, wherein said layer based on Ge (30) has a Ge content strictly greater than 50% and preferably greater than 95%, and optionally the method further comprising, before the step of depositing (210) the layer Ge (30), at least the following step:

    - Depositing (120) at least one buffer layer (20) of silicon-germanium (SiGe) having a germanium content of between 20% and 40%.

13. Method (100) for producing a waveguide according to the preceding claim, wherein the encapsulation layer (50) and the shell (40) are made from of silicon-germanium (SiGe), the germanium contents in said shell (40) and said encapsulation layer (50) being between 20% and 40% and optionally wherein the shell (40) has a thickness $e_{shell}$ of between 100 nm and 500 nm.

14. Method (100) for producing a waveguide according to any one of claims 12 to 13, wherein $T_{epitaxy\ shell} \leq 650°C$.

15. Method (100) for producing a waveguide according to any one of claims 12 to 14, wherein $T_{epitaxy\ encapsulation} \leq 850°C$.

FIG. 1

FIG. 2

FIG. 3a

FIG. 3b

| Cœur SiGe – MIR 3-8µm | Cœur Ge – MIR 8-15µm |
|---|---|

Fournir un substrat Si

Nettoyage en chimie humide « HF last »

Recuits haute T°C sous $H_2$

$T_1 \geq 800\ °C$      $T_1 \geq 800\ °C$

Epitaxie SiGe

Cycles thermiques courts sous $H_2$

Dépôt d'une couche à base de Ge

*Epitaxie SiGe*   $T_{2a} \leq 850\ °C$     *Epitaxie Ge*   $T_{2b} \leq 750\ °C$

Cycles thermiques courts sous $H_2$

Formation du cœur du guide d'onde

*Lithographie / Gravure*      *Lithographie / Gravure*

Recuits basse T°C sous $H_2$

$T_{3a} \leq 750\ °C$      $T_{3b} \leq 650\ °C$

Epitaxie basse T°C de la coquille formant partiellement la gaine du guide d'onde

*Epitaxie Si, $T_{4a} \leq 750\ °C$*      *Epitaxie SiGe, $T_{4b} \leq 650\ °C$*

Dépôt de la couche d'encapsulation formant partiellement la gaine du guide d'onde

*Epitaxie Si, $T_{5a} \leq 1000\ °C$*      *Epitaxie SiGe, $T_{5b} \leq 850\ °C$*

<u>FIG. 4</u>

$e_{coquille}$

$e_{coeur}$

40

31

10

**FIG. 5d**

10

**FIG. 5a**

$e_{encapsulation}$

50

40

31

10

**FIG. 5e**

30

10

**FIG. 5b**

33

35

31

34

32

10

**FIG. 5c**

10 — FIG. 6a

31 — 20 — 10 — FIG. 6d

20 — 10 — FIG. 6b

$e_{coquille}$ — $e_{coeur}$ — 40 — 31 — 20 — 10 — FIG. 6e

31 — 20 — 10 — FIG. 6c

$e_{encapsulation}$ — 50 — 40 — 31 — 20 — 10 — FIG. 6f

**EP 3 495 860 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **MICKAEL BRUN et al.** Low loss SiGe graded index waveguides for mid-IR applications. *journal OPTICS EXPRESS,* vol. 22